# EUROPÄISCHE PATENTANMELDUNG

(11) **EP 4 297 249 A1**
(43) Veröffentlichungstag der Anmeldung: **27.12.2023**
(21) Anmeldenummer: 23179199.7
(22) Anmeldetag: 14.06.2023
(51) Int. Cl.: H02K 5/10, H02K 5/24, H05K 5/00, H05K 7/14

(54) **LEITERPLATTEN IN EINEM MOTOR**

(30) Priorität: 22.06.2022 DE 102022115567
(71) Anmelder: ebm-papst Mulfingen GmbH & Co. KG, 74673 Mulfingen (DE)
(72) Erfinder: Walter, Manuel, 74523 Schwäbisch Hall (DE); Letter, Tobias, 97980 Bad Mergentheim (DE)
(74) Vertreter: Otten, Roth, Dobler & Partner mbB Patentanwälte

(57) **Zusammenfassung**

Vorrichtung zur Fixierung einer Leiterplatte 1 innerhalb eines Gehäuses eines elektrischen Motors umfassend ein erstes Gehäuseteil 2, ein zweites Gehäuseteil 3, sowie ein Isolationsteil 5, wobei das Isolationsteil 5 zwischen dem ersten Gehäuseteil 2 und dem zweiten Gehäuseteil 3 angeordnet ist, sodass die Gehäuseteile 2, 3 mittels des Isolationsteils 5 zumindest abschnittsweise voneinander beabstandet sind, wobei das Isolationsteil 5 eine Hartkomponente 6 und eine Weichkomponente 7 umfasst, wobei das Isolationsteil 5 mindestens ein Federelement 10 zur Ausübung einer Anpresskraft auf das erste Gehäuseteil 2 umfasst wobei die Hartkomponente 6 wenigstens einen Niederhalter 8 umfasst, wobei der Niederhalter 8 wenigstens ein Andrückelement 9, zur Ausübung einer Haltekraft auf die Leiterplatte 1, aufweist, wobei die Weichkomponente 7 zur Bereitstellung einer Dichtung zwischen den Gehäuseteilen ausgebildet ist, wobei das Federelement 10, im Bereich des Niederhalters 8, auf der einem Anschlagbereich 11, in Richtung der Haltekraft, gegenüberliegenden Seite des Isolationsteils 5, angeordnet ist.

## Beschreibung

Die vorliegende Erfindung betrifft das technische Gebiet der mechanischen Fixierung von Leiterplatten in einem Motor.

Um die im Betrieb eines elektrischen Motors auf elektrische Kontakte von Leiterplatten auftretenden Kräfte bei Schock- und Schwingungsbelastungen zu minimieren, werden die Leiterplatten üblicherweise im Stator mittels an einem Flansch oder an einem Elektronikgehäuses befestigten Kühlkörper mechanisch im Stator fixiert und niedergehalten.

Hierbei werden in der Regel Wärmeleitmaterialien der Art von GapPads zwischen den zu kühlenden Bauteilen und den Kühlkörpern eingesetzt. Diese GapPads werden durch den Kühlkörper verpresst, wodurch die entsprechende Kraft zum Niederhalten erzeugt wird.

Andere Arten zur Fixierung der Leiterplatte sind einerseits das Anschrauben der Leiterplatte im Flansch und somit der Vormontage als Steuereinheit, oder andererseits das Anschrauben der Leiterplatte im Stator.

Das Anbringen im Sinne von Aufkleben der GapPads birgt bei der Fertigung Zeit und Kostennachteile, da dies erfolgen muss und dadurch ein vollautomatisierter Herstellungsprozess verlangsamt und behindert wird. Bei einer Vollautomatisierung ist ein aufdosierter GapFiller nur eingeschränkt von Vorteil, da dieser im Gegensatz zu GapPads ein Niederhalten von Leiterplatten nicht ermöglicht.

Technische Aufgabe der vorliegenden Erfindung ist es eine alternative Möglichkeit zur Fixierung von Leiterplatten in einem elektrischen Motor zu finden.

Die technische Aufgabe wird durch einen Gegenstand mit den technischen Merkmalen nach dem unabhängigen Anspruch gelöst. Vorteilhafte Ausführungsformen sind Gegenstand der abhängigen Ansprüche, der Beschreibung und der Zeichnungen.

Im Sinne der Erfindung wird unter einer Hartkomponente ein Bauteil aus einem Kunststoff, beispielsweise einem Thermoplast, verstanden und unter einer Weichkomponente ein Bauteil aus einem Kunstastoff, beispielsweise einem thermoplastischen Elastomer, verstanden, das elastisch ist und eine geringere Härte aufweist. Hierbei kann die Weichkomponente als zweite Komponente in einem Zweikomponenten-Spritzgussverfahren an die Hartkomponente angespritzt sein.

Gemäß einem Aspekt wird die Aufgabe der Erfindung gelöst durch eine Vorrichtung zur Fixierung einer Leiterplatte innerhalb eines Gehäuses eines elektrischen Motors umfassend ein erstes Gehäuseteil, ein zweites Gehäuseteil, sowie ein Isolationsteil, wobei das Isolationsteil zwischen dem ersten Gehäuseteil und dem zweiten Gehäuseteil angeordnet ist, sodass die Gehäuseteile mittels des Isolationsteils zumindest abschnittsweise voneinander beabstandet sind, wobei das Isolationsteil eine Hartkomponente und eine Weichkomponente umfasst, wobei das Isolationsteil mindestens ein Federelement zur Ausübung einer Anpresskraft auf das erste Gehäuseteil umfasst wobei die Hartkomponente wenigstens einen Niederhalter umfasst, wobei der Niederhalter wenigstens ein Andrückelement, zur Ausübung einer Haltekraft auf die Leiterplatte, aufweist, wobei die Weichkomponente zur Bereitstellung einer Dichtung zwischen den Gehäuseteilen ausgebildet ist, wobei das Federelement im Bereich des Niederhalters, auf der einem Anschlagbereich, in Richtung der Haltekraft, gegenüberliegenden Seite des Isolationsteils, angeordnet ist.

Bei einer vollautomatisierten Fertigung kann in vorteilhafter Weise auf ein Aufklebens eines GapPads verzichtet und ein Auftragen eines GapFillers ermöglicht werden. Ein Niederhalten der Leiterplatte kann, trotz der pastenartigen Konsistenz des GapFillers, mittels des Isolationsteils ermöglicht werden. Weitere Teile und zusätzliche Montagekosten können entfallen und eine zügige und kostensparende Herstellung kann ermöglicht werden.

In einer technisch vorteilhaften Ausführungsform der Vorrichtung ist vorgesehen, dass das Federelement als Verdickung der Weichkomponente ausgebildet ist, wobei insbesondere die Federkraft des Federelements in Abhängigkeit der Geometrie des Federelements ausgebildet ist.

Hierdurch kann ein zusätzlicher Schritt bei der Herstellung eingespart werden, indem ein zusätzliches Anbringen oder Ausformen des Federelements verhindert wird. Kostengünstig und einer vollautomatisierten Herstellung vorteilhaft zuträglich kann das Federelement den Anforderungen entsprechend bei der Herstellung jeweils angepasst werden und flexibel in seinen physikalischen Eigenschaften konfiguriert sein. Beispielsweise kann das Federelement zylindrisch ausgebildet sein, um bei einer Stauchung eine lineare Federkraft aufzuweisen, oder beispielsweise spitz zulaufend ausgebildet sein, um eine für die jeweilige Anforderung entsprechenden Gradienten der Federkraft aufzuweisen.

In einer weiteren technisch vorteilhaften Ausführungsform der Vorrichtung ist vorgesehen, dass die Weichkomponente zumindest teilweise als Dichtelement, insbesondere als eine Dichtlippe ausgebildet ist.

Hierdurch können weitere Kosten zusätzlicher Bauteile eingespart und das Einsetzen und Verbinden weiterer Bauteile verhindert werden.

In einer weiteren technisch vorteilhaften Ausführungsform der Vorrichtung ist vorgesehen, dass eine im montierten Zustand auf das Dichtelement wirkende Anpresskraft des ersten Gehäuseteils und des zweiten Gehäuseteils, insbesondere mittels der Weichkomponente, entkoppelt ist von einer im montierten Zustand auf die Leiterplatte wirkende Haltekraft des Andrückelements.

Vorteilhaft kann hierdurch ein Anpressdruck beispielsweise beim Anflanschen der Gehäuseteile unabhängig von dem Anpressdruck gewählt werden, der ein Niederhalten der Leiterplatte ermöglicht. Hierdurch kann gezielt eine optimale Fixierung der Leiterplatte ermöglicht und gleichzeitig ein optimales Verschließen oder Abdichten der Gehäuseteile ermöglicht werden.

Weiterhin ist in einer technisch vorteilhaften Ausführungsform der Vorrichtung vorgesehen, dass der Niederhalter wenigstens einen Anschlagbereich zur axialen Fixierung der Leiterplatte aufweist.

Hierdurch kann ein optimales Fixieren der Leiterplatte in weiteren Raumrichtungen ermöglicht werden, was für eine verbesserte Stabilität sorgen kann und ein ungewolltes Verrutschen der Leiterplatte im Betrieb des Motors verhindern kann.

Drüber hinaus ist in einer technisch vorteilhaften Ausführungsform der Vorrichtung vorgesehen, dass der Niederhalter einen Führungsbereich, insbesondere einen Vorsprung oder Steg, zur lateralen Positionierung des Isolationsteils innerhalb der Gehäuseteile aufweist.

Bei der vollautomatisierten Fertigung kann ein solcher Führungsbereich größere Fehlertoleranzen beim Zusammenbau der Vorrichtung und somit eine schnellere Fertigung ermöglicht werden, da die einzelnen Bauteile selbstorientierend zusammenwirken können.

Außerdem ist in einer technisch vorteilhaften Ausführungsform der Vorrichtung vorgesehen, dass die Weichkomponente mit der Hartkomponente des Isolationsteils zumindest abschnittsweise als einstückiges Bauteil, insbesondere als Zweikomponenten-Spritzgussteil ausgebildet ist.

Hierdurch können zusätzliche Herstellungsschritte und Produktionsverfahren eingespart werden, da nicht nur eine geringere Anzahl einzelner Bauteile eingesetzt werden können, sondern diese auch kostengünstig herstellbar werden.

Weiterhin ist in einer technisch vorteilhaften Ausführungsform der Vorrichtung vorgesehen, dass der Niederhalter einteilig, insbesondere material-einstückig an der Hartkomponente, bevorzugt als federnder Bereich der Hartkomponente, ausgebildet ist.

Dies ermöglicht in vorteilhafter Weise eine verbesserte Stabilität des Isolationsteils, da etwaige Verbindungsstellen entfallen können.

Darüber hinaus ist in einer technisch vorteilhaften Ausführungsform der Vorrichtung vorgesehen, dass das Isolationsteil wenigstens teilweise aus einem elektrisch oder thermisch isolierenden Material, insbesondere Kunststoff, ausgebildet ist.

Vorteilhaft kann das Isolationsteils hierdurch individuell und flexibel auf bereichsabhängige Anforderungen der Konstruktion angepasst werden und kostengünstige Materialien eingesetzt werden.

Außerdem ist in einer technisch vorteilhaften Ausführungsform der Vorrichtung vorgesehen, dass der zweite Gehäuseteil als Stator des Motors ausgebildet ist oder ein Stator des Motors in einem Innenraum aufnehmbar ist.

Hierdurch kann ermöglicht werden, dass ein zusätzliches Gegenstück des Gehäuseteils entfällt und das Gehäuseteil an bereits bestehende Strukturen des elektrischen Motors angebracht werden kann.

In einer weiteren technisch vorteilhaften Ausführungsform der Vorrichtung ist vorgesehen, dass die Haltekraft auf die Leiterplatte in ihrer Wirkrichtung einer in axialer Richtung des Motors wirkenden Kraft entspricht.

Somit kann die Fixierung der Leiterplatte verbessert und eine in axialer Richtung des Motors ausgeführte Montage vereinfacht werden.

Ausführungsbeispiele der Erfindung sind in den Zeichnungen dargestellt und werden im Folgenden näher beschrieben.

Es zeigen:
- Fig. 1: eine perspektivische Detailansicht der Vorrichtung;
- Fig. 2: eine perspektivische Darstellung einer Oberseite des Isolationsteils;
- Fig. 3: eine perspektivische Darstellung einer, zu der in Fig. 2 gezeigten Oberseite gegenüberliegenden, Unterseite des Isolationsteils;
- Fig. 4: eine Detailansicht des Andrückelements; und
- Fig. 5: eine Detailansicht des Federelements.

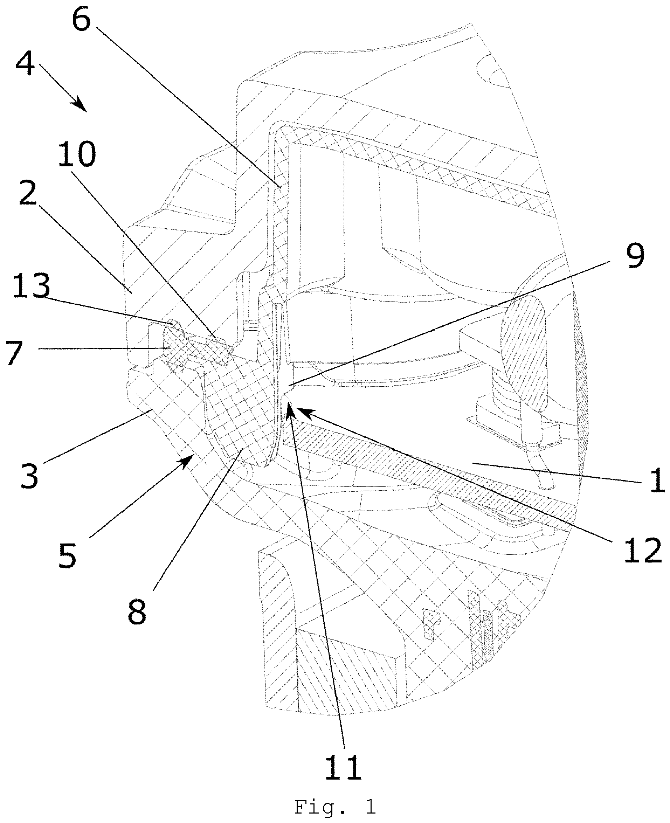

Figur 1 zeigt eine perspektivische Detailansicht einer Vorrichtung zur Fixierung einer Leiterplatte innerhalb eines Gehäuses eines elektrischen Motors. In diesem montierten Zustand befindet sich zwischen einem ersten Gehäuseteil und einem zweiten Gehäuseteil ein Isolationsteil, sodass die Gehäuseteile voneinander beabstandet sind.

Das als einstückiges Bauteil dargestellte Isolationsteil umfasst eine Hartkomponente, eine Weichkomponente, sowie ein Federelement. Das Federelement ist zur Ausübung einer Anpresskraft auf das erste Gehäuseteil als Verdickung der Weichkomponente ausgebildet. Die Weichkomponente ist zur Bereitstellung einer Dichtung zwischen den Gehäuseteilen als Dichtlippe ausgebildet. Die Hartkomponente umfasst einen einteilig an ihr ausgebildeten Niederhalter, wobei dieser ein Andrückelement zur Ausübung einer Haltekraft auf die Leiterplatte, sowie einen Anschlagbereich zur axialen Fixierung der Leiterplatte aufweist.

Weiterhin dargestellt ist dass das Federelement, im Bereich des Niederhalters, auf der einem Anschlagbereich, in Richtung der Haltekraft, gegenüberliegenden Seite des Isolationsteils angeordnet ist, wobei die Haltekraft auf die Leiterplatte in ihrer Wirkrichtung einer in axialer Richtung des Motors wirkenden Kraft entspricht.

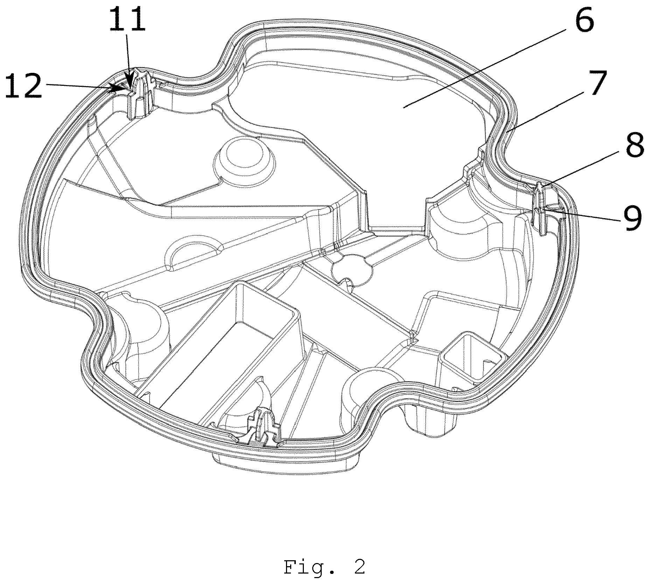

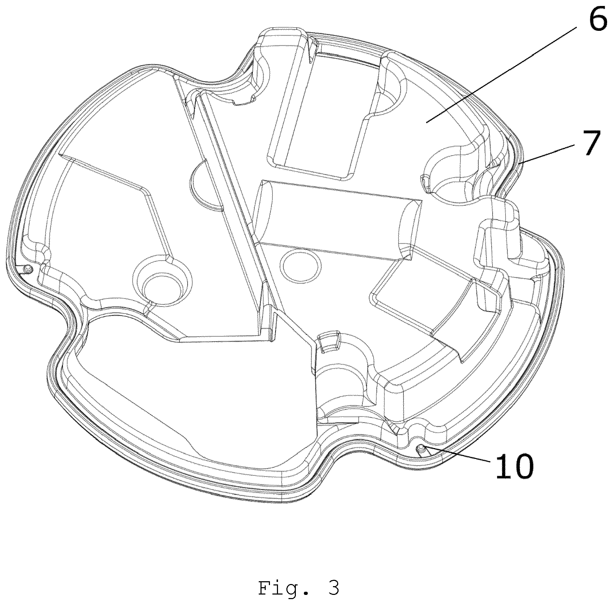

In den Figuren 2 und 3 ist jeweils eine perspektivische Darstellung des Isolationsteils dargestellt. In Figur 2 ist eine untere Seite des Isolationsteils dargestellt und in Figur 3 ist eine hierzu gegenüberliegende obere Seite des Isolationsteils dargestellt. In einer Zusammenschau der Figuren 2 und 3 sind die Weichkomponente, die Hartkomponente, Niederhalter, Andrückelemente, Federelemente, sowie Anschlagbereich und Führungsbereich zu sehen. Weiterhin ist in dieser Zusammenschau der Figuren 2 und 3 erkennbar, dass das Federelement, im Bereich des Niederhalters, auf der an einem Anschlagbereich in Richtung der Haltekraft gegenüberliegenden Seite des Isolationsteils, angeordnet ist.

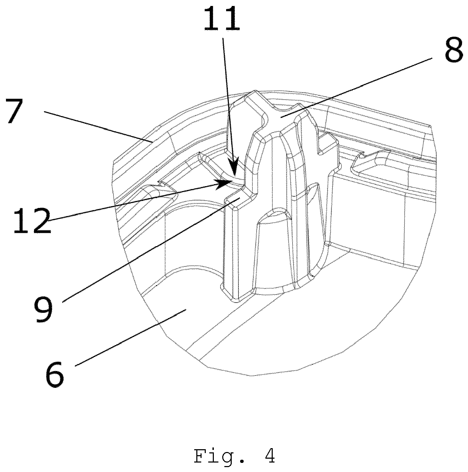

In der Figur 4 ist eine Detailansicht eines in Figur 2 bereits dargestellten Andrückelements dargestellt. Zu sehen sind die Hartkomponente, die Weichkomponente, der Führungsbereich, das Andrückelement, sowie der Niederhalter.

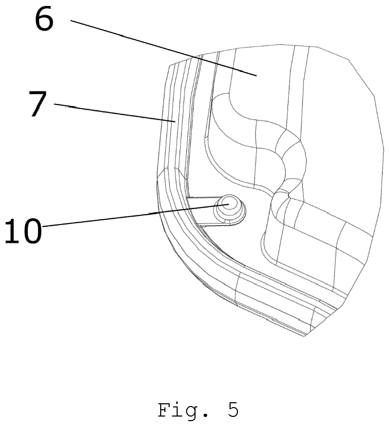

In der Figur 5 ist eine Detailansicht eines in Figur 3 bereits dargestellten Federelements dargestellt. Zu sehen sind auch hier die Hartkomponente und die Weichkomponente, wobei das Federelement als Verdickung der Weichkomponente und einstückig mit dieser ausgebildet ist.

### Bezugszeichenliste:

- 1: Leiterplatte
- 2: erstes Gehäuseteil
- 3: zweites Gehäuseteil
- 4: Motor
- 5: Isolationsteil
- 6: Hartkomponente
- 7: Weichkomponente
- 8: Niederhalter
- 9: Andrückelement
- 10: Federelement
- 11: Anschlagbereich
- 12: Führungsbereich

## Patentansprüche

1. Vorrichtung zur Fixierung einer Leiterplatte (1) innerhalb eines Gehäuses eines elektrischen Motors umfassend
ein erstes Gehäuseteil (2),
ein zweites Gehäuseteil (3),
sowie ein Isolationsteil (5),
wobei das Isolationsteil (5) zwischen dem ersten Gehäuseteil (2) und dem zweiten Gehäuseteil (3) angeordnet ist, sodass die Gehäuseteile (2, 3) mittels des Isolationsteils (5) zumindest abschnittsweise voneinander beabstandet sind,
wobei das Isolationsteil (5) eine Hartkomponente (6) und eine Weichkomponente (7) umfasst,
wobei das Isolationsteil (5) mindestens ein Federelement (10) zur Ausübung einer Anpresskraft auf das erste Gehäuseteil (2) umfasst
wobei die Hartkomponente (6) wenigstens einen Niederhalter (8) umfasst,
wobei der Niederhalter (8) wenigstens ein Andrückelement (9), zur Ausübung einer Haltekraft auf die Leiterplatte (1), aufweist,
wobei die Weichkomponente (7) zur Bereitstellung einer Dichtung zwischen den Gehäuseteilen ausgebildet ist,
**dadurch gekennzeichnet, dass**
das Federelement (10), im Bereich des Niederhalters (8), auf der einem Anschlagbereich (11), in Richtung der Haltekraft, gegenüberliegenden Seite des Isolationsteils (5), angeordnet ist.

2. Vorrichtung nach Anspruch 1 **dadurch gekennzeichnet, dass** das Federelement (10) als Verdickung der Weichkomponente (7) ausgebildet ist, wobei insbesondere die Federkraft des Federelements (10) in Abhängigkeit der Geometrie des Federelements (10) ausgebildet ist.

3. Vorrichtung nach einem der vorangehenden Ansprüche **dadurch gekennzeichnet, dass** die Weichkomponente (7) zumindest teilweise als Dichtelement, insbesondere als eine Dichtlippe ausgebildet ist.

4. Vorrichtung nach einem der vorangehenden Ansprüche **dadurch gekennzeichnet, dass** eine im montierten Zustand auf das Dichtelement wirkende Anpresskraft des ersten Gehäuseteils (2) und des zweiten Gehäuseteils (3), insbesondere mittels der Weichkomponente (7), entkoppelt ist von einer im montierten Zustand auf die Leiterplatte (1) wirkende Haltekraft des Andrückelements (9).

5. Vorrichtung nach einem der vorangehenden Ansprüche **dadurch gekennzeichnet, dass** der Anschlagbereich zumindest teilweise am Niederhalter (8) und insbesondere zur axialen Fixierung der Leiterplatte (1) ausgebildet ist.

6. Vorrichtung nach einem der vorangehenden Ansprüche **dadurch gekennzeichnet, dass** der Niederhalter (8) einen Führungsbereich (12), insbesondere einen Vorsprung oder Steg, zur lateralen Positionierung des Isolationsteils (5) innerhalb der Gehäuseteile (2, 3) aufweist.

7. Vorrichtung nach einem der vorangehenden Ansprüche **dadurch gekennzeichnet, dass** die Weichkomponente (7) mit der Hartkomponente (6) des Isolationsteils (5) zumindest abschnittsweise als einstückiges Bauteil, insbesondere als Zweikomponenten-Spritzgussteil ausgebildet ist.

8. Vorrichtung nach wenigstens einem der vorangehenden Ansprüche **dadurch gekennzeichnet, dass** der Niederhalter (8) einteilig, insbesondere material-einstückig an der Hartkomponente (6), bevorzugt als federnder Bereich der Hartkomponente (8), ausgebildet ist.

9. Vorrichtung nach einem der vorangehenden Ansprüche **dadurch gekennzeichnet, dass** das Isolationsteil (5) wenigstens teilweise aus einem elektrisch oder thermisch isolierenden Material, insbesondere Kunststoff, ausgebildet ist.

10. Vorrichtung nach einem der vorangehenden Ansprüche **dadurch gekennzeichnet, dass** der zweite Gehäuseteil (3) als Stator des Motors ausgebildet ist oder ein Stator des Motors in einem Innenraum aufnehmbar ist.

11. Vorrichtung nach einem der vorangehenden Ansprüche **dadurch gekennzeichnet, dass** die Haltekraft auf die Leiterplatte (1) in ihrer Wirkrichtung einer in axialer Richtung des Motors wirkenden Kraft entspricht.
